# EUROPEAN PATENT APPLICATION

(11) **EP 1 054 447 A1**
(43) Date of publication of application: **22.11.2000**
(21) Application number: 00304269.4
(22) Date of filing: 19.05.2000
(51) Int. Cl.: H01L 23/498

(54) **Surface mount millimeter wave IC package**

(30) Priority: 21.05.1999 US 317100
(71) Applicant: THE WHITAKER CORPORATION, Wilmington, Delaware 19808 (US)
(72) Inventor: Ziegner, Bernhard Alphonso, Tyngsboro, MA 01879 (US); Sletten, Robert John, Bow, NH 03304 (US); Soshea, Eric, Snohomish, WA 98290 (US)
(74) Representative: Warren, Keith Stanley

(57) **Abstract**

A packaged integrated circuit (10), includes a multiple-layer interconnect (16) comprising a dielectric layer (32) disposed between a base layer (34) and a conductive transmission layer (36). The conductive layer (36) is electrically connectable to a substrate (11) and an integrated circuit (18). The packaged integrated circuit (10) includes a base member (12) which engages the base layer (34) of the interconnect (16)

## Description

The present invention relates generally to packaged integrated circuits and more specifically relates to a novel packaged integrated circuit which provides an interconnect electrically connected to the integrated circuit and electrically connectable to a substrate.

It is desirable to provide a low cost packaged millimeter wave or microwave integrated circuit.

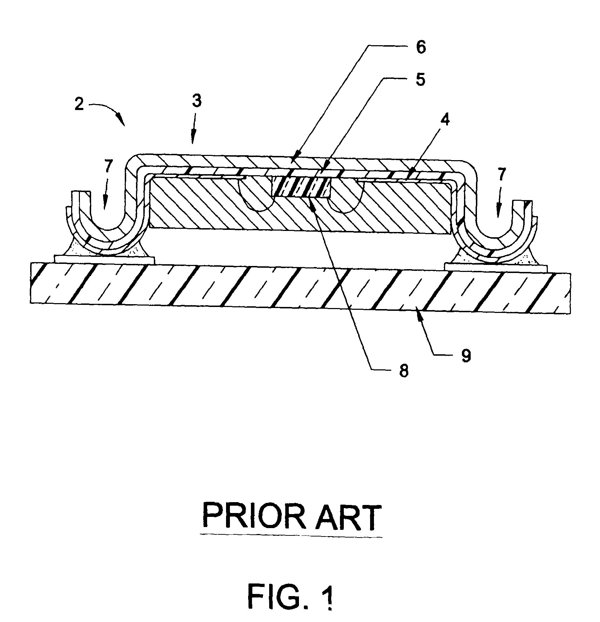

One known integrated circuit package 2 is illustrated in FIGURE 1, and has a layered lead structure 3 comprising a transmission layer 4, an insulating layer 5, and a base layer 6. The base layer 6 is a relatively thick layer of copper. The insulating layer 5 is polyimide dielectric layer laminated onto the base layer 6. The transmission layer 4 comprises multiple copper foil conductive traces that have been patterned onto the insulating layer 5. Such a laminated structure is commercially available from Mitsui Toatsu Chemicals Inc. under the trademark KOOL-BASE®. The layered lead structure 3 is press formed to have radiused ends 7 on a perimeter thereof, where the radiused ends 7 curl outward as shown in FIGURE 1. The lead structure 3 retains its shape due to the strength and memory of the copper metal base layer 6. The press form results in an indentation at a center of the lead structure. An IC 8 is attached to the center and wirebonded to the conductive traces. The indentation is then filled with molding compound to complete the package. Attachment to a printed wiring board 9 is by way of engagement between the radiused portion 7 of the lead along a line tangent to the radius and a surface on the printed wiring board 9. Attachment to a printed wiring board 9 may be made by way of conventional surface mount solder manufacturing techniques. This style of package is termed an integrated leadless chip carrier (ILCC).

The ILCC package is not, however, appropriate for millimeter wave integrated circuits due to the use of molded packaging, poor heat removal and inefficient coupling of microwave energy into and out of the package through the laminated lead structure 3 which employs only a direct transmission line connection between the enclosed integrated circuit 8 and the external printed wiring board 9 to which the package 2 is mounted. In particular, the ILCC package is inappropriate for high powered ICs. Microwave integrated circuits, particularly power devices, generate a significant amount of heat; therefore, sufficient heat dissipation is important. In the ILCC style package, heat must dissipate through the transmission lines and through the copper base layer 6 onto the printed circuit board surface and into the air. Dissipation of heat through narrow transmission lines or onto the printed wiring board surface is insufficient to provide proper cooling for some ICs.

Therefore, there is a need for a packaged millimeter wave integrated circuit having efficient energy coupling into and out of the structure and improved heat dissipation capabilities that can be mounted to a printed circuit board using conventional surface mount technology.

Accordingly, it is a general objectof the present invention to provide a packaged integrated circuit, more particularly, a packaged microwaveor millimeter wave integrated circuit, which is capable of being surface mounted to a printed wiring board and to provide efficient coupling of microwave or millimeter wave energy into and out of the package structure while providing efficient heat dissipation.

Briefly, and in accordance with the above, the present invention provides a packaged integrated circuit which includes a multiple-layer interconnect including a dielectric layer disposed between a base layer and a conductive transmission layer. The conductive layer is electrically connectable to a substrate and is electrically connected to the integrated circuit. The packaged integrated circuit includes a base member which engages the base layer of the multiple-layer interconnect.

In order that the present invention may be more readily understood, reference will now be made to the accompanying drawings, in which:
FIGURE 1 is a side, elevational view, partially in section, of a prior art integrated circuit package;
FIGURE 2 is a perspective view of a packaged integrated circuit in accordance with either one of two embodiments of the present invention, showing the packaged integrated circuit mounted on a substrate;
FIGURE 3 is an exploded perspective view of the packaged integrated circuit illustrated in FIGURE 2 in the case where the packaged integrated circuit is provided in accordance with a first embodiment of the present invention;
FIGURE 4 is an exploded perspective view of the first embodiment, with the view being taken from a bottom side of the packaged integrated circuit;
FIGURE 5 is a cross-sectional view of the first embodiment, taken along line A-A of FIGURE 2;
FIGURE 6 is an exploded perspective view of the packaged integrated circuit illustrated in FIGURE 2 in the case where the packaged integrated circuit is provided in accordance with a second embodiment of the present invention;
FIGURE 7 is a cross-sectional view of the second embodiment, taken along line A-A of FIGURE 2; and
FIGURE 8 is a top, elevational view of a preferred layout of conductive traces adjacent a left side of either one of the packaged integrated circuits illustrated in FIGURES 2-7.

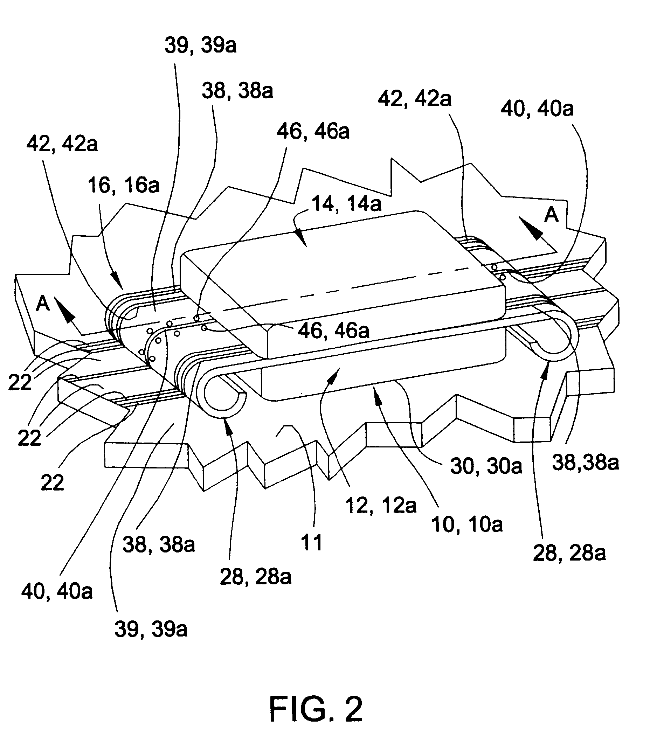

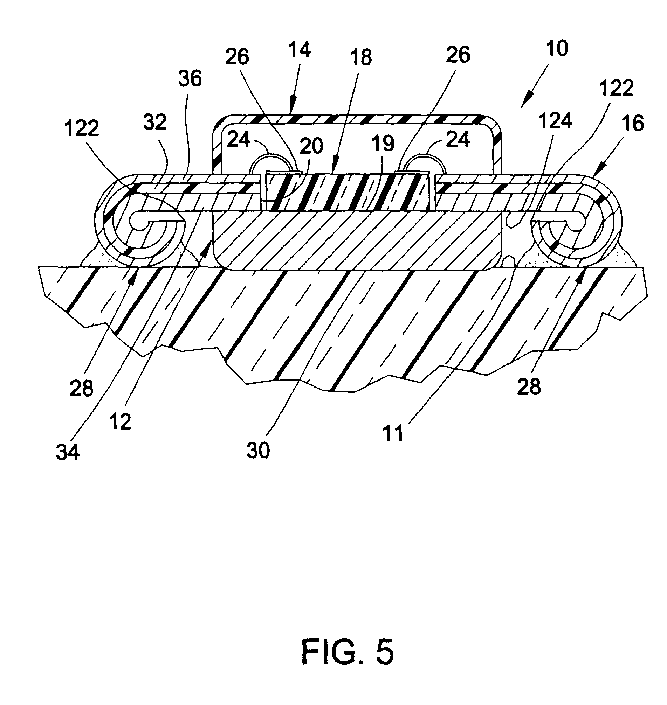

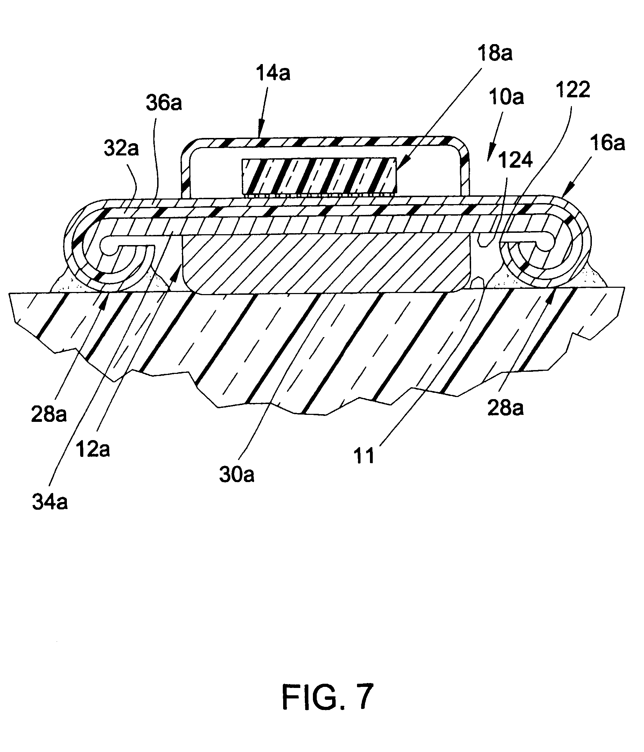

Referring to the accompanying drawings, FIGURE 2 illustrates a packaged integrated circuit 10,10a which is in accordance with either one of two embodiments of the present invention. As shown, the package 10,10a is mountable on a substrate 11. FIGURE 5 is a cross-sectional view, taken along line A-A of FIGURE 2, of the package 10 mounted on the substrate and FIGURE 7 is a cross-sectional view, taken along line A-A of FIGURE 2, of the package 10a mounted on the substrate. Because the components of the two embodiments 10 and 10a are quite similar, similar reference numerals are used to identify similar components, and the reference numeral "a" is added in association with the second embodiment package 10a.

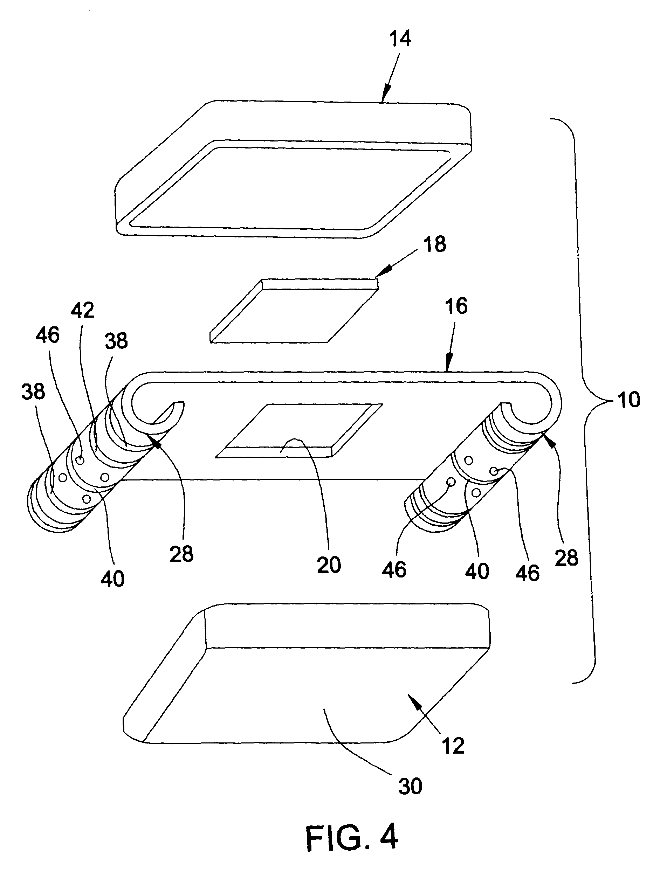

FIGURES 2-5 relate to the first embodiment package 10, and FIGURES 2, 6 and 7 relate to the second embodiment package 10a. As shown in FIGURES 2-7, both packages 10 and 10a include a base 12, 12a, a cover 14, 14a and an interconnect 16, 16a. Additionally, when the base 12, 12a and cover 14, 14a are engaged with the interconnect 16, 16a, as illustrated in FIGURES 2, 5 and 7, a housing is formed, and within the housing is an integrated circuit 18, 18a, such as a glass millimeter wave circuit or a GaAs millimeter wave circuit. In the first embodiment package 10, as shown in FIGURE 5, the integrated circuit 18 is mounted on the top surface 19 of the base 12, disposed in a opening 20 in the interconnect 16. In the second embodiment package 10a, as shown in FIGURE 7, the integrated circuit 18a is flip chip mounted directly on the interconnect 16. Both embodiment packages 10 and 10a consist of a base 12, 12a, an integrated circuit 18, 18a, an interconnect 16, 16a and a cover 14, 14a, with the integrated circuit 18, 18a contained within the housing formed when the base 12, 12a and cover 14, 14a are engaged with the interconnect 16, 16a.

As mentioned, both packages 10 and 10a are mountable on a substrate 11, as shown in FIGURES 2, 5 and 7. The substrate 11 may be a printed wiring or circuit board having conductive traces 22 thereon. As will be described later herein, the mounting of the package 10, 10a on the substrate preferably provides that the integrated circuit 18, 18a within the package 10, 10a becomes electrically connected to conductive traces 22 on the substrate 11 via the interconnect 16, 16a of the package 10, 10a.

Preferably, the base component 12, 12a of the package 10, 10a is made of a tungsten-copper metal matrix composite using a sintered or metal-injection-molding manufacturing process. However, other metals, such as copper-molybdenum can be used. Preferably, the base 12, 12a is gold plated with an electrolytic nickel underplating. Regardless of what material the base 12, 12a is made, at least with regard to the first embodiment package 10a, it is preferred that the base 12, 12a is formed of a material which is compatible with the integrated circuit 18, 18a. Specifically, it is preferred that the base 12, 12a have a coefficient of thermal expansion (CTE) that is compatible to that of the integrated circuit 18, 18a since, as mentioned, in the first embodiment package 10, the integrated circuit 18 is mounted directly on the top surface 19 of the base 12, disposed in an opening 20 in the interconnect 16. The base 12, 12a acts as a heat sink for the integrated circuit 18, 18a in both packages 10, 10a. It is preferred that the top surface 19 of the base 12 be relatively flat to provide a good contact surface. This enhances efficient thermal transfer.

As shown in FIGURE 5, in the first embodiment package 10, the interconnect 16 is mounted on the top surface 19 of the base 12. For example, the interconnect 16 may be epoxied to the top surface 19 of the base using a B-stage film adhesive. In the first embodiment package 10, the interconnect 16 is electrically connected, such as by bond wires 24, to contacts 26 on the integrated circuit 18 when the integrated circuit 18 is mounted to the base 12, and the integrated circuit 18 is disposed in the opening 20 provided in the interconnect 16.

In the second embodiment package 10a which is illustrated in FIGURES 2, 6 and 7, the interconnect 16a is not provided with an opening for receiving the integrated circuit 18a, and the integrated circuit 18a is flip chip mounted directly onto the interconnect 16a.

In both embodiments 10 and 10a, the interconnect 16, 16a extends from opposite sides of the base 12, 12a, and electrically connects to the substrate 11, as shown in FIGURES 2, 5 and 7, such as to conductive traces 22 thereon (see FIGURE 2), when the package 10, 10a is mounted. Specifically, a radius 28, 28a may be provided generally at each end of the interconnect 16, 16a where each radius 28, 28a provides bond points which contact and electrically connect to the substrate 11. As shown, preferably the radii 28, 28a form curls which curl inward. This provides for particularly efficient electrical mounting of the package 10, 10a to the substrate 11. Preferably, the bond points and the bottom surface 30, 30a of the base are generally coplanar thereby providing that the bond points and bottom surface 30, 30a of the base member 12, 12a simultaneously mate with the substrate 11 during assembly. Because in both embodiments 10, 10a the integrated circuit 18, 18a is electrically connected to the interconnect 16, 16a, the electrical connections between the interconnect 16, 16a and the substrate 11 which result when either package 10, 10a is mounted on the substrate 11 provides that the integrated circuit 18, 18a within the package 10, 10a becomes electrically connected to the substrate 11.

The preferred structure of the interconnect 16, 16a of both embodiment packages 10, 10a will now be described with reference to FIGURES 5 and 7. The interconnect 16, 16a is preferably a metalized polyimide film formed of multiple layers. Specifically, an insulating layer 32, 32a is disposed between a base layer 34, 34a and a transmission layer 36, 36a, and the base layer 34, 34a engages the base member 12, 12a component of the package 10, 10a. The engagement of the base layer 34, 34a and the base member 12, 12a enhances the heat dissipation capabilities of the package 10, 10a by providing efficient thermal transfer, which is very important for microwave applications. The base layer 34, 34a of the interconnect 16, 16a is metal, preferably copper, with a thickness of approximately 200 µm. The insulating layer 32, 32a is a polyimide dielectric layer which is laminated or otherwise adhered to the base layer 34, 34a. The insulating layer 32, 32a preferably has a thickness of about 42 µm. Preferably, a combined thickness of the dielectric layer 32, 32a and the base layer 34, 34a is substantially equal to a thickness of the integrated circuit 18, 18a. This substrate material (copper base layer 34, 34a, polyimide dielectric layer 32, 32a and a transmission layer 36, 36a) is presently commercially available from Mitsui Toatsu Chemical Company under the trademark KOOL-BASE®. The transmission layer 36, 36a of the interconnect 16, 16a comprises patterned conductive traces 38, 38a (see FIGURES 2, 3, 4 and 6), and may be formed of gold plated copper traces having a thickness of about 18 µm. As shown in FIGURES 2, 3, 4 and 6, the transmission layer may include bias lines 40, 40a as well as transmission lines 42, 42a and wide traces 39, 39a. As discussed above and as shown in FIGURE 5, in the first embodiment package 10, an opening 20 is provided on the interconnect 16 for receiving the integrated circuit 18, and the integrated circuit 18 is mounted directly onto the top surface 19 of the base 12. As discussed above and as shown in FIGURE 7, in the second embodiment package 10a, the integrated circuit 18a is flip chip mounted directly onto the interconnect 16a surface, and more specifically, onto the conductive transmission layer 36a thereof.

As mentioned, and as shown in FIGURES 2, 5 and 7, when either package 10, 10a is mounted on the substrate 11, the interconnect 16, 16a preferably electrically connects with the substrate 11. Specifically, the transmission layer 36, 36a of the interconnect 16, 16a contacts the substrate 11, and electrically connects with conductive traces 22 on the substrate. For example, the transmission lines 42, 42a may be used as the RF medium connecting to the conductive traces 22 on the substrate 11. Therefore, because the interconnect 16, 16a is electrically connected to the integrated circuit 18, 18a within the package 10, 10a, the conductive traces 22 on the substrate 11 become electrically connected to the integrated circuit 18, 18a via the transmission lines 42, 42a of the interconnect.

This provides a continuous translation between the substrate 11 surface and the package 10, 10a interior (specifically, the points of electrical connection between the integrated circuit 18, 18a and interconnect 16, 16a) with a minimum number of impedance discontinuities. As shown in FIGURES 2, 3 and 6, preferably plated blind vias 46, 46a are provided on the interconnect 16, 16a that connect the top-level ground to the base layer 34 of the interconnect. Preferably, the vias 46, 46a are located at close intervals to assure mode-free operation of the interconnect 16, 16a. More specifically, it is preferred that the vias be significantly closer together than a one-quarter wavelength of the highest operating frequency.

As mentioned, and as shown in FIGURES 2, 5 and 7, in both embodiments a cover 14, 14a is engaged with the base 12, 12a to form a housing. Specifically, the cover 14, 14a is epoxied to the base 12, 12a to form the housing and encloses the integrated circuit 18, 18a as well as the electrical connections between the interconnect 16, 16a and the integrated circuit 18, 18a. The cover 14, 14a may be epoxied to the interconnect 16, 16a using a B-stage epoxy seal. The cover 14, 14a is preferably formed using an injection molded polymer, for example a PEI polymer. The cover may be ceramic.

Assembly of both packages 10, 10a will now be described. First, the interconnect 16, 16a is installed on the base 12, 12a. As mentioned, this can be performed using a B-stage epoxy attachment process. Next, with regard to the first embodiment package 10 illustrated in FIGURE 5, conductive epoxy is applied to the top surface 19 of the base 12 in the area where the integrated circuit 18 will be mounted. With regard to the second embodiment package 10a illustrated in FIGURE 7, conductive epoxy is applied to the interconnect 16a in those areas where the integrated circuit 18a will be mounted. The conductive epoxy is preferably a low modulus material. Application of the epoxy, can be performed using any of several techniques including screen printing, pad printing and syringe dispensing. A solder reflow process can also be utilized for the attachment of the integrated circuit 18a to the interconnect 16a. Then, the integrated circuit 18, 18a is positioned on the top surface 19 of the base 12 in the opening 20 in the interconnect 16 (in the first embodiment package 10) or directly on the interconnect 16a (in the second embodiment package 10a), and the epoxy is cured or the solder reflowed. Then, the interconnects 16 are bonded to the integrated circuit 18 using a thermosonic process in the first embodiment. Next, an epoxy seal ring is applied to a seal edge of the cover 14, 14a, the cover 14, 14a is attached to the base 12, 12a, and the epoxy seal ring is cured. Subsequently, the package 10, 10a is preferably subjected to electrical testing before the package 10, 10a is mounted on the substrate 11.

When either package 10 or 10a is mounted on the substrate, a reflow solder process can be employed. The assembled package is initially positioned on the corresponding traces 22 of the printed wiring board 11 and the final alignment is achieved during the reflow operation based on the surface tension of the molten solder. Additionally, as the assembled package 10, 10a is contacted with the printed wiring board 11, the interconnect bond points (the points at which the interconnect 16, 16a contacts the printed wiring board 11) and the bottom surface 30, 30a of the base 12, 12a preferably mate simultaneously with the printed wiring board 11. Preferably, the transmission layer 36,36a of the interconnect 16, 16a electrically connects with conductive traces 22 on the printed wiring board 11 thereby providing that the conductive traces 22 are electrically connected to the integrated circuit 18, 18a via the interconnect 16, 16a.

A preferred pattern of conductive traces 22 on the substrate 11 will now be described along with some preferred dimensions of either package 10, 10a previously described.

Preferably, the pattern of conductive traces 22 on the substrate 11 which is adjacent one side of the package 10, 10a is generally identical to the pattern which is adjacent the other side of the package 10, 10a, and may effectively be a mirror image thereof.

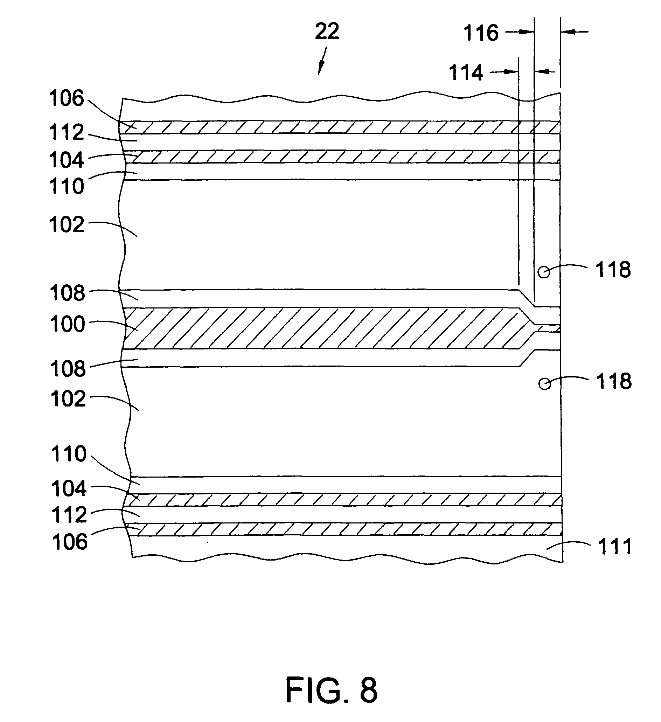

A preferred layout of conductive traces 22 on the substrate 11 adjacent the left side of the package 10, 10a is shown in FIGURE 8. Preferably, the layout along the right side is merely a mirror image of what is shown in FIGURE 8.

As shown, preferably the traces consist of a center trace 100 and other traces 102, 104, 106 on each side of the center trace 100 with gaps 108, 110, 112 between the traces. Preferably, the center trace 100 is 29 mils wide, and the adjacent gaps 108 are 10 mils wide. Preferably, the side traces 102 are 45.5 mils wide, while dimension 114 is 12 mils and dimension 116 is 40 mils. As shown, preferably a plated-through hole 118 is provided in each wide trace 102.

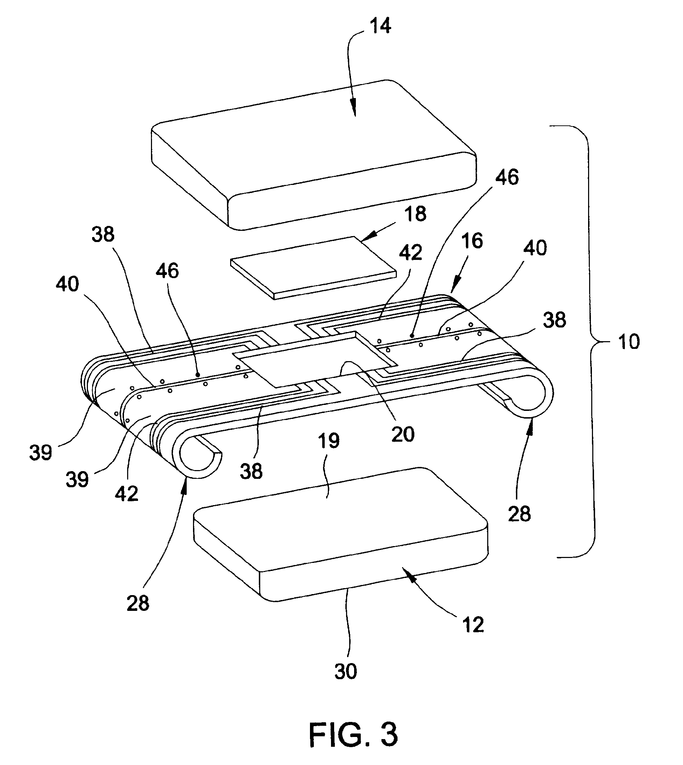

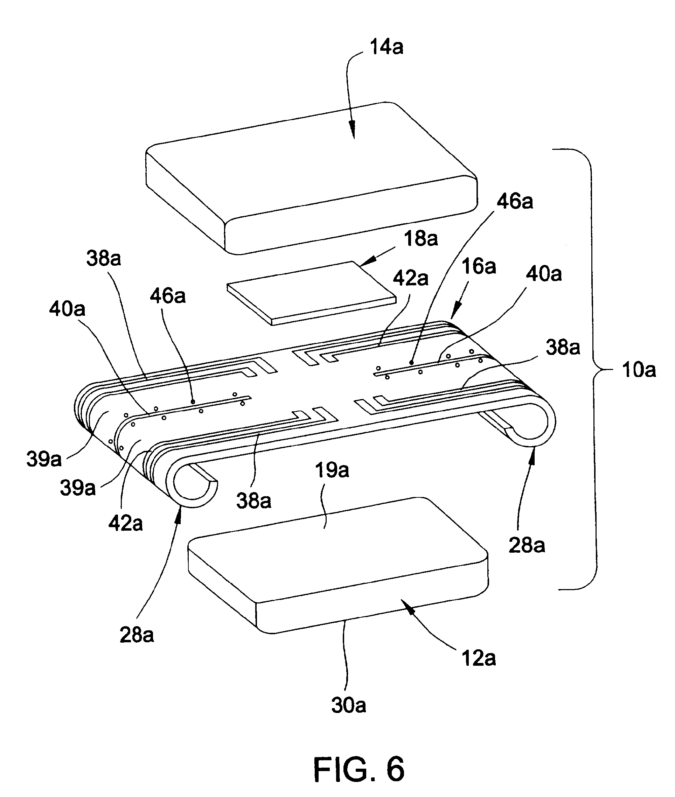

Preferably, the package 10, 10a contacts the center trace 100 at the portion thereof defined by dimension 116. Specifically, the center trace 40, 40a on each package 10, 10a (see FIGURES 3 and 6) is preferably 5 mils wide and contacts the center trace 100 on the substrate 11 at the portion defined by dimension 116. Preferably, the wide traces 39, 39a are about 62.5 mils wide and are spaced away from the center trace 40, 40a about 5 mils. Preferably, the holes 46, 46a on the package 10, 10a are about 10 mils wide, and the curls 28, 28a at the end of the interconnect 16, 16a each have a horizontal radius of 28 mils and a vertical radius of 37.5 mils. The ends of the curls 28, 28a are preferably about 31.2 mils above the substrate 11, while bottom surface 124 of the interconnect 16, 16a is preferably about 69.2 mils away from the substrate 11 when the package 10, 10a is mounted thereon. Preferably, the dielectric portion of the substrate is 10 mils wide while the dielectric portion of the interconnect 16, 16a is about 2 mils wide.

Of course, other dimensions can be used with respect to the traces and interconnect 16, 16a while still staying within the scope of the present invention.

While embodiments of the present invention are shown and described, it is envisioned that those skilled in the art may devise various modifications of the present invention without departing from the scope of the appended claims.

## Claims

1. A packaged integrated circuit (10,10a) comprising
an integrated circuit (18, 18a);
a multiple-layer interconnect (16,16a)including a dielectric layer (32,32a) disposed between a base layer (34,34a) and a conductive transmission layer (36,36a), which is electrically connectable to a substrate (11) and electrically connected to said integrated circuit; characterised by
a base member (12,12a) engaging said base layer (34,34a) of said multiple-layer interconnect.

2. A packaged integrated circuit as recited in claim 1, wherein a surface (30,30a) of said base member (12,12a) is arranged with respect to bond points (28,28a) of said conductive layer of said multiple-layer interconnect such that said surface of said base member contacts said substrate when said bond points of said conductive layer of said multiple-layer interconnect are electrically connected to said substrate.

3. A packaged integrated circuit as recited in claim 1 or 2, including a cover member (14, 14a) engaging said multiple-layer interconnect.

4. A packaged integrated circuit as recited in claim 3, wherein said cover member is formed one of a molded polymer and ceramic.

5. A packaged integrated circuit as recited in any of claims 1 to 4, wherein said multiple-layer interconnect comprises a dielectric layer (32,32a) laminated to a conductive base layer (34,34a), and a layer of conductive traces (38,38a) on said dielectric layer.

6. A packaged integrated circuit as recited in claim 5, wherein said multiple-layer interconnect includes at least one via (46,46a)electrically connecting said conductive base layer to at least one of said conductive traces.

7. A packaged integrated circuit as recited in claim 5, wherein said multiple-layer interconnect includes at least two vias (46,46a)electrically connecting said conductive base layer to at least one of said conductive traces, wherein said vias are spaced apart at not more than one-quarter wavelength of a highest operating frequency of said package integrated circuit.

8. A packaged integrated circuit as recited in any of claims 1 to 7, wherein a combined thickness of said dielectric layer and said base layer is substantially equal to a thickness of said integrated circuit.

9. A packaged integrated circuit as recited in any of claims 1 to 8, wherein said integrated circuit is wire bonded to said conductive layer of said multiple-layer interconnect.

10. A packaged integrated circuit as recited in any of claims 1 to 9, wherein said integrated circuit is flip chip mounted to said conductive layer of said multiple-layer interconnect.

11. A packaged integrated circuit (10) as recited in any of claims 1 to 9, wherein said integrated circuit is disposed in an opening (20) in said interconnect and engaged with said base member.

12. A packaged integrated circuit as recited in claim 3 or 4, wherein said cover member is epoxy sealed to said multiple-layer interconnect enclosing said integrated circuit and enclosing a point at which said integrated circuit is electrically connected to said conductive layer of said multiple-layer interconnect.

13. A packaged integrated circuit as recited in any of claims 1 to 12, wherein said multiple-layer interconnect includes inwardly facing curls at ends thereof.

14. A packaged millimeter wave integrated circuit (10,10a) comprising:
a millimeter wave integrated circuit (18,18a);
a multiple-layer interconnect (16,16a) including a dielectric layer (32,32a) disposed between a conductive base layer (34,34a) and a conductive layer (36,36a), said conductive trace layer having bond points (28,28a) electrically connectable to a substrate, said conductive trace layer being electrically connected to said millimeter wave integrated circuit, said multiple-layer interconnect including at least one via electrically connecting said conductive base layer to said conductive trace layer;
a base member (12,12a) laminated to said conductive base layer of said multiple-layer interconnect, wherein a surface (30,30a) of said base member is arranged with respect to said bond points of said conductive trace layer of said multiple-layer interconnect such that said surface of said base member contacts said substrate when said bond points of said conductive trace layer of said multiple-layer interconnect are electrically connected to said substrate; and
a cover member (14,14a) engaging said multiple-layer interconnect, wherein said cover member encloses said millimeter wave integrated circuit and encloses points at which said millimeter wave integrated circuit is electrically connected to said conductive trace layer of said multiple-layer interconnect.

15. A packaged millimeter wave integrated circuit as recited in claim 14, wherein a combined thickness of said dielectric layer and said conductive base layer is substantially equal to a thickness of said millimeter wave integrated circuit.

16. A method of assembling and mounting a packaged integrated circuit to a substrate, wherein said packaged integrated circuit includes a multiple-layer interconnect which includes a dielectric layer disposed between a base layer and a conductive layer, and wherein said packaged integrated circuit includes a base member contactably engaged with said base layer of said multiple-layer interconnect, said method comprising: adhering an integrated circuit on said base member; electrically connecting said integrated circuit to said conductive layer of said multiple-layer interconnect; disposing a cover member on said multiple-layer interconnect; and simultaneously electrically connecting said conductive layer of said multiple-layer interconnect to said substrate and adhering a surface of said base member to said substrate thereby mounting said packaged integrated circuit to said substrate.
